# EUROPÄISCHE PATENTSCHRIFT

(11) **EP 2 909 901 B1**
(45) Veröffentlichungstag und Bekanntmachung des Hinweises auf die Patenterteilung: **09.12.2020**
(21) Anmeldenummer: 13779802.1
(22) Anmeldetag: 17.10.2013
(51) Int. Cl.: H02B 1/28, H02B 1/56, H05K 7/20, H01H 9/04

(54) **EXPLOSIONSGESCHÜTZTES GEHÄUSE MIT EINEM VENTILATOR**
EXPLOSION-PROOF HOUSING WITH A VENTILATOR
BOÎTIER ANTIDÉFLAGRANT ÉQUIPÉ D'UN VENTILATEUR

(30) Priorität: 19.10.2012 DE 102012110001
(43) Veröffentlichungstag der Anmeldung: 26.08.2015
(73) Patentinhaber: R. Stahl Schaltgeräte GmbH, 74638 Waldenburg (DE)
(72) Erfinder: RÖSSLER, Klaus, 74676 Niedernhall (DE)
(74) Vertreter: Rüger Abel Patentanwälte PartGmbB
(86) Internationale Anmeldenummer: PCT/EP2013/071745
(87) Internationale Veröffentlichungsnummer: WO 2014/060528

(56) Entgegenhaltungen:
- EP-A1- 1 022 830
- CN-A- 102 355 808
- DE-U1- 20 306 668
- JP-U- S5 773 992

## Beschreibung

Die vorliegende Erfindung betrifft eine Anordnung, die ein explosionsgeschütztes Gehäuse mit einem relativ zur Umgebung durch Gehäusewände des Gehäuses gekapselten Innenraum und eine Ventilatoranordnung mit einem Ventilator. Das Gehäuse ist insbesondere druckfest gekapselt gemäß DIN EN 60079-1.

In solchen Gehäusen werden elektrische bzw. elektronische Komponenten in explosionsgefährdeten Umgebungen angeordnet, die als Zündquelle für eine explosionsfähige Umgebung dienen könnte. Problematisch ist dabei, dass derartige elektrische bzw. elektronische Komponenten Wärme erzeugen, die aus dem gegenüber der Umgebung gekapselten Innenraum des Gehäuses nur unzureichend oder mit viel Aufwand abgeführt werden kann. Wird die Temperatur im Innenraum zu groß, kann die Funktionsfähigkeit der Komponenten beeinträchtigt werden.

Ein explosionsgeschützter Schaltschrank ist zum Beispiel aus DE 10 2008 009 552 A1 bekannt. An diesen Schaltschrank ist ein Kühlgerät mit explosionsgeschützten Kühlgerätekomponenten angekoppelt. Diese sind in einem weiteren Anreihschrank angeordnet, der mit dem explosionsgeschützten Schaltschrank verbunden ist. Der explosionsgeschützte Schaltschrank und der Anreiheschrank sind über Dichtelemente dicht miteinander gekoppelt. Im Anreiheschrank ist eine Schottwand vorhanden, durch die zwei Gruppen von Kühlgerätekomponenten im Anreiheschrank luftdicht voneinander getrennt werden. In einem Teil des Anreiheschrankes ist dadurch eine Überdruckkapselung für eine Gruppe von Kühlgerätekomponente gebildet. Die beiden Gruppen sind über luftdicht durch die Schottwand geführte Verbindungsleitungen miteinander verbunden. Aus dem explosionsgeschützten Schaltschrank kann Luft in einen Wärmetauscher im Anreiheschrank geführt, dort über eine Kältemittel gekühlt und wieder zurück in den Schaltschrank geführt werden.

DE 10 2008 022 000 A1 beschreibt ein Gehäuse, mit einem gegenüber der Umgebung gegen das Eindringen von Staub, Nässe oder Insekten dicht geschlossenen Innenraum. Zur Wärmeabfuhr ist das Gehäuse doppelwandig ausgeführt. Über Ventilatoren wird im Spalt zwischen den beiden Gehäusewänden ein Luftstrom zur Kühlung des abgeschlossenen Innenraums erzeugt.

Ein Schaltschrank mit einem Wärmetauscher ist auch aus DE 197 37 531 A1 bekannt. Die Wände des Schaltschrankes weisen Durchbrechungen für die Luftzirkulation auf. Die Wärmetauscherkassette hat zwei fluidisch voneinander getrennte Kreisläufe: durch den einen Kreislauf strömt die zu kühlende Luft aus dem Innenraum des Schaltschrankes. Durch den anderen Kreislauf strömt die Außenluft, die in der Wärmetauscherkassette Wärme aufnimmt. Die Luftströme werden von jeweils einem Ventilator erzeugt.

Ein Wärmetauscher für einen Schaltschrank mit zwei fluidisch voneinander getrennten Kreisläufen ist ferner in DE 197 01 100 A1 beschrieben. Dabei sind die Ventilatoren zur Erzeugung der Luftströme für die beiden Kreisläufe durch einen gemeinsamen Elektromotor angetrieben.

US 2010/0288467 A1 beschreibt ein explosionsgeschütztes Gehäuse mit einem außen am Gehäuse angeordneten Wärmetauscher. Die das Wärmetauschermedium führenden Rohre durchdringen die Gehäusewand. Im Innenraum des Gehäuses ist eine Wärmetauscherplatte angeordnet. Ein Ventilator kann in der Nähe der Wärmetauscherplatte im Gehäuse oder außerhalb des Gehäuses angeordnet sein.

Die aus dem Stand der Technik bekannten Lösungen sind konstruktiv sehr aufwendig und dadurch teuer. Insbesondere das Anordnen von Kanälen oder Leitungen durch die Wand eines gekapselten, elektrische oder elektronische Komponenten aufweisenden Innenraums nach außen muss den Anforderungen des Explosionsschutzes gerecht werden, weshalb, wie etwa bei DE 10 2008 022 000 A1, Anbaugehäuse notwendig werden, die wiederum zumindest teilweise explosionsgeschützt ausgeführt werden müssen.

Ein feuerbeständiges Gehäuse ist aus DE 203 06 668 U1 bekannt. Zur Kühlung eines Bauteils ist im Inneren eine Ventilatoranordnung angeordnet, die an einer Gehäusewand eine abwärtsgerichtete Strömung erzeugt.

CN 102355808 A und JP S57-73992 U beschreiben auch jeweils ein Gehäuse mit einer im Gehäuse angeordneten Ventilatoranordnung, die eine zirkulierende Strömung erzeugt. CN 102355808 A offenbart die Merkmale des Oberbegriffs des Patentanspruches 1.

Es kann daher als Aufgabe der vorliegenden Erfindung angesehen werden, ein explosionsgeschütztes Gehäuse zur Aufnahme von elektrischen und/oder elektronischen Komponenten zu schaffen, das eine ausreichende Kühlung mit konstruktiv einfachen Mitteln gewährleistet und den Anforderungen des Explosionsschutzes gerecht wird.

Diese Aufgabe wird gelöst durch eine Anordnung Anordnung aufweisend: ein explosionsgeschütztes Gehäuse mit einem relativ zur Umgebung durch Gehäusewände gekapselten, explosionsgeschützten Innenraum, in dem elektrische und/oder elektronische Komponenten angeordnet sind, eine im Innenraum angeordnete Ventilatoranordnung mit einem Ventilator, wobei die Ventilatoranordnung eine Ansaugöffnung und eine unterhalb der Ansaugöffnung angeordnete Ausströmöffnung aufweist, und wobei die Ventilatoranordnung im Innenraum eine vertikal nach unten gerichtete Kühlungsströmung entlang eines Gehäusewandabschnitts einer seitlichen Gehäusewand hervorruft, die frei ist von kühlungsmediumdurchströmten Öffnungen, einen an der Außenseite des Gehäuses ein Außenkühlkörper, wobei die Ventilatoranordnung an einer seitlichen Gehäusewand angeordnet ist, wobei die von der Kühlungsströmung angeströmte seitliche Gehäusewand von einer Tür oder Klappe gebildet ist, einen in der Kühlungsströmung (S) im Innenraum (13) vorhandenen Innenkühlkörper (24), wobei der Innenkühlkörper (24) und der Außenkühlkörper (30) an dem Gehäusewandabschnitt (22) der seitlichen Gehäusewand (11) angeordnet sind und durch die seitliche Gehäusewand (11) voneinander getrennt sind, und wobei innen und außen Sacklöcher in den Gehäusewandabschnitt (22) eingebracht sind, die den Gehäusewandabschnitt (22) nicht vollständig durchsetzen, sondern lediglich Vertiefungen bilden, in denen Wärmeleitelemente (34) angeordnet sind, um den Wärmeübergang zwischen dem Gehäusewandabschnitt (22) und dem Innenkühlkörper (24) und dem Außenkühlkörper (30) zu verbessern..

Die Anordnung weist ein Gehäuse eine im Innenraum angeordnete Ventilatoranordnung mit einem Ventilator und einen Innenkühlkörper auf. Der Ventilator erzeugt eine Kühlungsströmung im Innenraum. Um die Anforderungen des Explosionsschutzes zu gewährleisten, wird die Kühlungsströmung nicht aus dem explosionsgeschützten Innenraum des Gehäuses herausgeführt, so dass keine zusätzlichen Explosionsschutzmaßnahmen erforderlich sind. Durch das explosionsgeschützte Gehäuse müssen keine Strömungskanäle für ein Kühlmedium hindurch geführt werden und im einfachsten Fall kann das Gehäuse unverändert bleiben. Die Strömung wird durch die Ventilatoranordnung entlang eines seitlichen Gehäusewandabschnitts gelenkt. Dennoch wird eine erheblich verbesserte Kühlung erreicht, so dass in einem vorgegebenen Volumen des Innenraums mehr oder leistungsstärkere elektrische bzw. elektronische Komponenten angeordnet werden können als bisher.

Die von der Kühlungsströmung angeströmte seitliche Gehäusewand ist von einer Tür oder Klappe gebildet. Die seitliche Gehäusewand erstreckt sich im Wesentlichen vertikal zwischen einer unteren und einer oberen Gehäusewand.

Bei der Beschreibung der Erfindung wird beispielhaft davon ausgegangen, dass der Innenraum mit Luft gefüllt ist. Es versteht sich, dass anstelle von Luft auch ein anderes Gas oder Gasgemisch, z.B. zur Inertisierung des Innenraums, vorhanden sein kann.

Der Ventilator ist so ausgerichtet, dass die Kühlungsströmung entlang eines Gehäusewandabschnitts einer der Gehäusewände von oben nach unten strömt und dort für eine Konvektionskühlung sorgt. Dabei wird die Wärmeübertragung zwischen der Luft im explosionsgeschützt gekapselten Innenraum des Gehäuse und dem Gehäusewandabschnitt verbessert, so dass durch die Wärmeleitung des Gehäusewandabschnitts eine verbesserte Wärmeabfuhr nach außen zur Umgebung hin erfolgen kann. Die Ansaugöffnung der Ventilatoranordnung ist vertikal oberhalb der Ausströmöffnung der Ventilatoranordnung angeordnet. Dadurch wird warme, nach oben im Innenraum strömende Luft angesaugt und durch den Ventilator nach unten entlang des Gehäusewandabschnitts der seitlichen Gehäusewand ausgestoßen. Dabei kühlt sich die Luft ab und trifft schließlich auf die untere Gehäusewand bzw. den Gehäuseboden. Die kühlere Luft verteilt sich entlang des Bodens und strömt im gesamten Innenraum des Gehäuses wieder nach oben. Durch diese gleichmäßige Durchmischung von wärmerer und abgekühlter Luft im gekapselten Innenraum stellt sich eine relativ gleichmäßige Lufttemperaturverteilung im Innenraum ein.

Dies hat den Vorteil, dass die elektronischen oder elektrischen Komponenten abhängig von konstruktiven Erfordernissen oder Randbedingungen relativ frei im Innenraum des Gehäuses angeordnet werden können. Bei einer unbewegten Atmosphäre im Innenraum bilden sich Luft- bzw. Gasschichten mit verschiedenen Temperaturen, wobei die Temperatur vertikal von unten nach oben im Innenraum zunimmt. Durch die Kühlungsströmung wird eine relativ homogene Temperaturverteilung erreicht, so dass auch wärmeempfindliche Komponenten im oberen Bereich des Innenraums angeordnet werden können.

Zu der Ventilatoranordnung kann neben dem Ventilator eine Luftleitanordnung gehören, die beispielsweise einen Luftleitkanal bildet. Die Ansaugöffnung und/oder die Ausströmöffnung der Ventilatoranordnung kann dann vom Luftleitkanal gebildet sein. Es ist alternativ auch möglich, auf die Luftleitanordnung zu verzichten, so dass die Ventilatoranordnung vom Ventilator gebildet ist. In diesem letzten Fall ist die Ansaugöffnung an der Ansaugseite des Ventilators und die Ausströmöffnung an der Ausströmseite des Ventilators vorgesehen.

Bei einem vorteilhaften Ausführungsbeispiel ist die Ansaugöffnung der Ventilatoranordnung im oberen Drittel oder im oberen Viertel des Innenraums angeordnet, beispielsweise an einer seitlichen Gehäusewand. Dadurch ist das Ansaugen von nach oben strömender wärmerer Luft im Innenraum verbessert.

An die Ansaugseite und/oder die Ausströmseite des Ventilators schließt sich vorzugsweise ein Strömungsraum entlang des angeströmten Gehäusewandabschnitts an. Der Strömungsraum ist frei von zu kühlenden elektrischen und/oder elektronischen Komponenten. Dadurch kann die Wärmeabgabe über den angeströmten Gehäusewandabschnitt nach außen ungehindert erfolgen.

Im Innenraum des Gehäuses ist der Innenkühlkörper vorhanden, der von der Kühlungsströmung durch den Ventilator beaufschlagt wird. Der Innenkühlkörper ist an dem angeströmten Gehäusewandabschnitt des Gehäuses angeordnet. Der Innenkühlkörper kann vom Gehäusewandabschnitt in den Innenraum hineinragende Vorsprünge bzw. Rippen aufweisen, um die angeströmte Oberfläche zu vergrößern und damit den Wärmetransport aus dem Innenraum nach außen zu verbessern.

Der Innenkühlkörper ist vorzugsweise in dem sich an den Ventilator anschließenden Strömungsraum angeordnet.

An dem Innenkühlkörper können in Strömungsrichtung der Kühlungsströmung verlaufende Kanäle vorhanden sein. Diese Kanäle können beispielsweise durch die quer vom Gehäusewandabschnitt wegragenden Rippen des Innenkühlkörpers gebildet sein. Die Kanäle können zumindest abschnittsweise auf ihrer dem Gehäusewandabschnitt abgewandten Seite geschlossen sein, um die Strömung bis zum Boden bzw. unteren Gehäusewandabschnitt zu leiten.

Es ist ferner vorteilhaft, wenn zwischen dem Innenkühlkörper und dem Ventilator eine Luftleitanordnung angeordnet ist, um das an der Ausströmseite des Ventilators ausströmende Gas auf den Innenkörper und insbesondere in die Kanäle des Innenkühlkörpers zu richten. Die Luftleitanordnung kann beispielsweise mehrere Leitbleche aufweisen. Diese können ringförmig oder U-förmig am Rand der Ausströmseite des Ventilators angeordnet sein.

An der Außenseite des Gehäuses ist ein Außenkühlkörper vorhanden. Der Außenkühlkörper ist an der Außenseite einer Gehäusewand befestigt und als separater Körper ausgeführt. Dadurch wird die Wärmeabgabe von der Gehäusewand an die Umgebung durch eine entsprechende vergrößerte Oberfläche verbessert.

Es sind sowohl der Innenkühlkörper, als auch der Außenkühlkörper an den von der Kühlungsströmung angeströmten Gehäusewandabschnitt angeordnet. Die Wärmeleitung vom Innenkühlkörper über den Gehäusewandabschnitt zum Außenkühlkörper ist dadurch verbessert. Vorzugsweise sind der Außenkühlkörper und/oder der Innenkühlkörper aus einem Material hergestellt, dessen Wärmeleitfähigkeit größer ist als die Wärmeleitfähigkeit des Materials des Gehäuses. Die Wärmeübertragung zwischen dem Innenkühlkörper und dem Außenkühlkörper erfolgt vorzugsweise ausschließlich mittelbar über den Gehäusewandabschnitt durch Wärmeleitung, um die Kapselung des explosionsgeschützten Gehäuses nicht zu beeinträchtigen oder zusätzliche Explosionsschutzmaßnahmen vorsehen zu müssen.

Zwischen dem Innenkühlkörper und/oder dem Außenkühlkörper einerseits und dem Gehäusewandabschnitt andererseits kann eine unmittelbare, flächige Verbindung hergestellt sein. Alternativ kann auch eine Wärmeleitschicht, die beispielsweise Grafit aufweist oder aus Grafit besteht, zwischen dem Gehäusewandabschnitt und wenigstens einem der beiden Kühlkörper angeordnet sein. Eine solche Wärmeleitschicht kann die Wärmeverteilung in der Ebene des Gehäusewandanschnitts verbessern.

Vorteilhafte Ausgestaltungen der Erfindung ergeben sich aus den abhängigen Patentansprüchen sowie der Beschreibung. Nachfolgend werden Ausführungsbeispiele der Erfindung und nicht erfindungsgemäße Beispiele anhand der beigefügten Zeichnung im Einzelnen erläutert. Es zeigen:
Figuren 1 bis 5 jeweils eine schematische perspektivische Darstellung eines nicht erfindungsgemäßen explosionsgeschützten Gehäuses, wobei die dem Betrachter zugewandte Gehäusewand zur Veranschaulichung des Innenraums des Gehäuses weggelassen wurde,
Figur 6 eine schematische Schnittdarstellung eines Ausführungsbeispiels einer erfindungsgemäßen Anordnung eines Innenkühlkörpers und eines Außenkühlkörper an einem Gehäusewandabschnitt des explosionsgeschützten Gehäuses,
Figur 7 eine schematische Schnittdarstellung eines nicht erfindungsgemäßen Beispiels zur Verbindung eines Innenkühlkörpers mit einem Außenkühlkörper und
Figuren 8 und 9 jeweils eine schematische Darstellung eines Ausführungsbeispiels einer Ventilatoranordnung mit einem Ventilator und einer Luftleitanordnung, wobei das Gehäuse nur teilweise veranschaulicht ist.

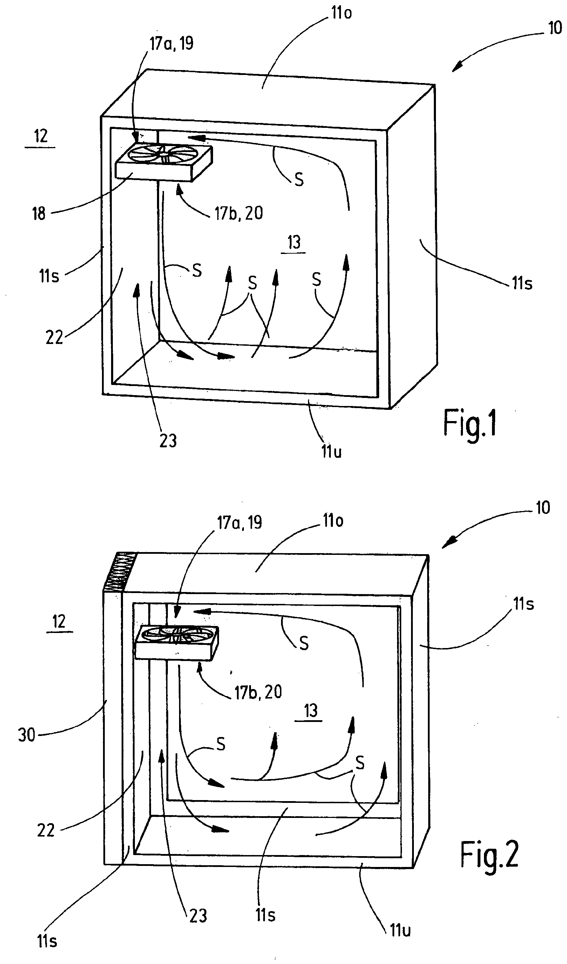

In den Figuren 1 bis 5 sind verschiedene Beispiele eines nicht erfindungsgemäßen explosionsgeschützten Gehäuses 10 stark schematisiert veranschaulicht. Das explosionsgeschützte Gehäuse 10 kann zum Beispiel in der Zündschutzart "druckfeste Kapselung" ausgeführt sein. Das Gehäuse 10 weist einen durch Gehäusewände 11 von der Umgebung 12 explosionsgeschützt getrennten Innenraum 13 auf.

In den Figuren 1 bis 5 sind nicht alle Gehäusewände 11 dargestellt, um den Innenraum 13 veranschaulichen zu können. Eine oder mehrere Gehäusewände können verschließbare Türen aufweisen, die in der Zeichnung nicht dargestellt sind.

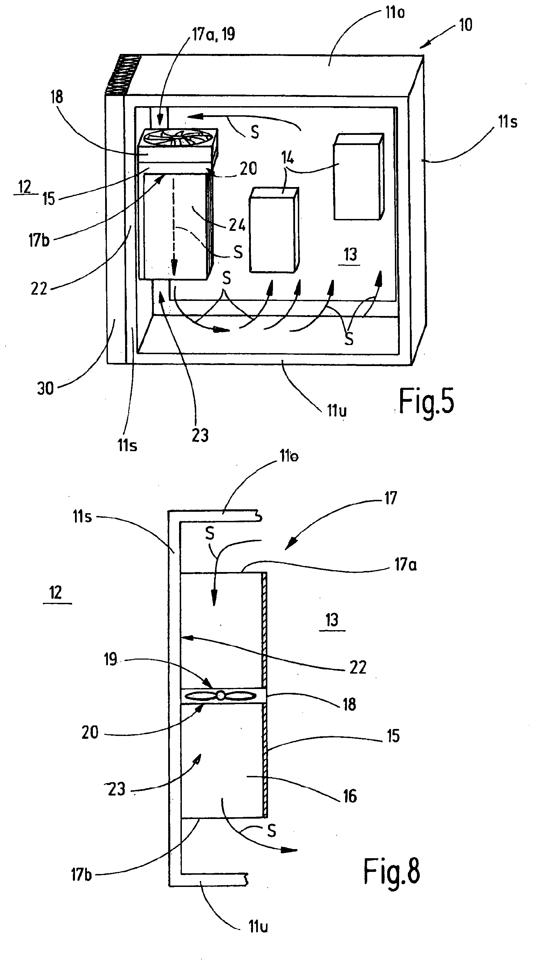

In dem Innenraum 13 ist wenigstens eine und sind vorzugsweise mehrere elektrische und/oder elektronische Komponenten 14 angeordnet. Diese Komponenten 14 sind beispielhaft und sehr schematisch in Figur 5 veranschaulicht. Beim Betrieb erzeugen diese Komponenten 14 Wärme, wodurch sich die Atmosphäre im Innenraum 13 erwärmt. Um den Temperaturanstieg im Innenraum 13 zu begrenzen, ist eine Kühlung des explosionsgeschützten Gehäuses 10 notwendig.

Hierfür ist im Innenraum 13 des Gehäuses 10 eine Ventilatoranordnung 17 mit einem Ventilator 18 angeordnet, der eine Kühlungsströmung S erzeugt. Die Kühlungsströmung S ist schematisch in den Figuren 1 bis 5 durch Pfeile illustriert. Die Kühlungsströmung S ist wegen der Kapselung des Gehäuses 10 auf den Innenraum 13 beschränkt. Die von der Ventilatoranordnung 17 erzeugte Kühlungsströmung S strömt entlang einer seitlichen Gehäusewand 11s. Diese angeströmte seitliche Gehäusewand 11s kann auch eine Tür oder Klappe aufweisen oder von einer Tür oder Klappe gebildet sein. Unter einer seitlichen Gehäusewand 11s ist eine Gehäusewand zu verstehen, die sich im Wesentlichen vertikal zwischen einer unteren Gehäusewand 11u und einer oberen Gehäusewand 11o erstreckt.

Die Ventilatoranordnung 17 weist eine Ansaugöffnung 17a und eine Ausströmöffnung 17b auf. Eine Ansaugseite 19 des Ventilators 18 ist der Ansaugöffnung 17a und eine Ausströmseite 20 des Ventilators 18 ist der Ausströmöffnung 17b zugeordnet. Die Ansaugöffnung 17a ist vertikal weiter oben angeordnet als die Ausströmöffnung 17b. Die Ansaugöffnung 17a und/oder die Ausströmöffnung 17b kann horizontal, schräg oder vertikal orientiert sein.

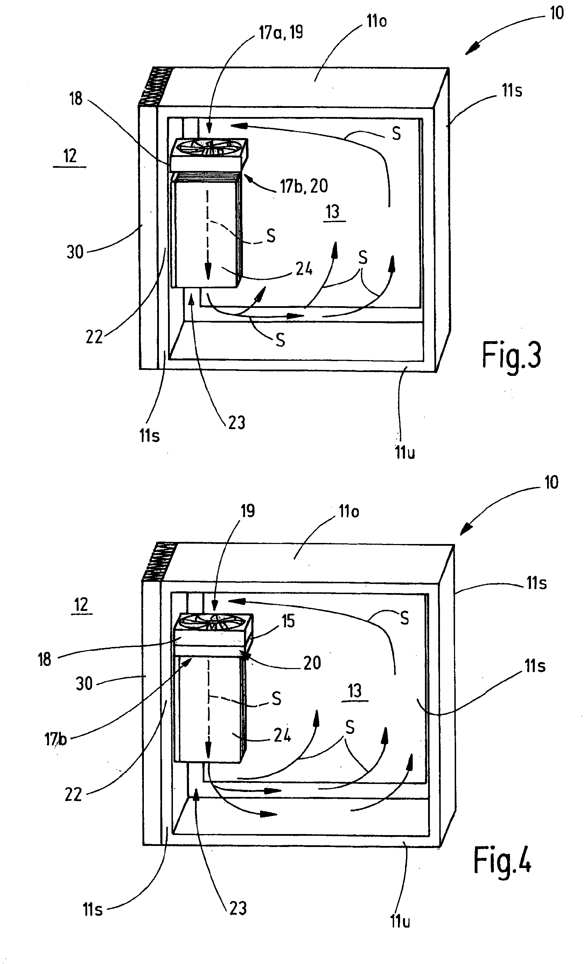

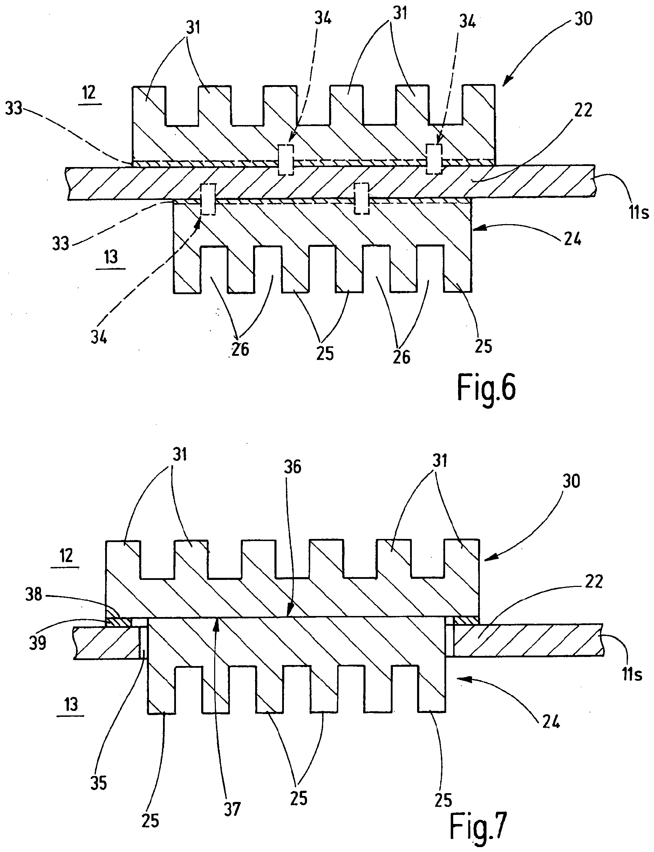

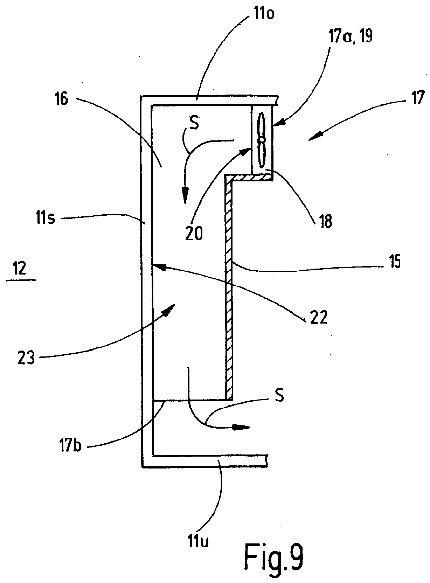

Zu der Ventilatoranordnung 17 gehört bei den Beispielen gemäß der Figuren 4, 5, 8 und 9 neben dem Ventilator 18 eine Luftleitanordnung 15, die beispielsweise einen Luftleitkanal 16 bildet. Die Ansaugöffnung 17a und/oder die Ausströmöffnung 17b der Ventilatoranordnung 17 ist vom Luftleitkanal 16 gebildet. Der Luftleitkanal 16 kann sich gerade entlang der seitlichen Gehäusewand 11s erstrecken (Figur 8) oder einen Bogen oder Knick aufweisen (Figur 9). Zumindest ein Abschnitt des Luftleitkanals 16 erstreckt sich unmittelbar entlang eines Gehäusewandabschnitts 22 einer seitlichen Gehäusewand 11s.

Es ist alternativ auch möglich, auf die Luftleitanordnung 15 zu verzichten (Figuren 1 bis 3), so dass die Ventilatoranordnung 17 vom Ventilator 18 gebildet ist. In diesem letzten Fall ist die Ansaugöffnung 17a an der Ansaugseite 19 des Ventilators 18 und die Ausströmöffnung 17b an der Ausströmseite 20 des Ventilators 18 vorgesehen.

Bei dem hier beschriebenen Beispiel besteht die im Innenraum 13 des Gehäuses 10 vorhandene und von der Umgebung 12 getrennte Atmosphäre aus Luft. Alternativ kann auch ein anderes Gas oder ein Gasgemisch im Innenraum vorhanden sein, wenn dieser beispielsweise inertisiert werden soll.

Wie in den Figuren 1 bis 5 und 8 veranschaulicht, ist der Ventilator 18 hier an einer seitlichen Gehäusewand 11s befestigt. Die seitliche Gehäusewand 11s ist ohne ein Strömungsmedium führende Kanäle, Durchbrechungen oder Öffnungen ausgeführt und besteht vorzugsweise aus einem naht- und fügestellenfrei hergestellten Teil aus einheitlichem Material, insbesondere Metall oder einer Metalllegierung. Die Ansaugöffnung 17a oder die Ansaugseite 19 des Ventilators 18 ist im oberen Bereich des Innenraums 13 angeordnet und beispielsweise im oberen Dritten oder im oberen Viertel des Innenraums 13. Die vom Ventilator 18 verursachte Luftströmung ist derart orientiert oder durch die Luftleitanordnung 15 geführt, dass die Kühlungsströmung S parallel oder schräg zu dem angeströmten Gehäusewandabschnitt 22 der seitlichen Gehäusewand 11s ausgerichtet ist.

Der Gehäusewandabschnitt 22 befindet sich an einer der seitlichen Gehäusewände 11s, an der beispielsweise auch der Ventilator 18 befestigt sein kann und schließt sich bei den Beispielen nach den Figuren 1 bis 5 und 9 an die Ausströmseite 20 an. Im Bereich dieses angeströmten Gehäusewandabschnitts 22 sind keine zu kühlenden Komponenten 14 im Innenraum 13 angeordnet, so dass ein komponentenfreier Strömungsraum 23 für die Kühlungsströmung S gebildet ist, um den Wärmeübergang von der Kühlungsströmung S über das Gehäuse 10 zur Umgebung 12 zu verbessern. Beim Beispiel nach Figur 8 sitzt der Ventilator 18 in einem Luftleitkanal 16 am Gehäusewandabschnitt 22.

Die Kühlungsströmung S trifft nach der Strömung durch den Strömungsraum 23 auf die untere Gehäusewand 11u auf, die den Boden des Gehäuses darstellt. Dort prallt die Kühlungsströmung S auf die Innenseite der untere Gehäusewand 11u und wird abgelenkt. Die durch die Kühlungsströmung S transportierte gekühlte Luft verteilt sich im Bereich der unteren Gehäusewand 11u. Wegen der im oberen Bereich des Innenraums 13 an der Ansaugöffnung 17a vom Ventilator 18 angesaugten warmen Luft strömt die kühlere Luft im Innenraum 13 nach oben und durchmischt sich dabei mit der wärmeren Luft. Im Innenraum entsteht dadurch eine relativ gleichmäßige Temperaturverteilung ohne Bereiche mit einer deutlich höheren Lufttemperatur. Dadurch erhöhen sich für die Konstrukteure die Freiheitsgrade bei der Anordnung von zu kühlenden Komponenten 14. Insbesondere können auch temperaturempfindlichere Komponenten 14 im oberen Bereich des Innenraums angeordnet werden, da sich dort keine deutlich höhere Temperatur einstellt als im unteren Bereich des Innenraums.

Im Anschluss an die Abströmseite 20 des Ventilators 18 und insbesondere im Strömungsraum 23 ist bei den Ausführungsformen gemäß der Figuren 3 bis 5 ein Innenkühlkörper 24 angeordnet. Der Innenkühlkörper 24 kann als separates Element ausgeführt und am angeströmten Gehäusewandabschnitt 22 befestigt sein. Es ist alternativ hierzu auch möglich, den Innenkühlkörper 24 durch den Gehäusewandabschnitt 22 auszubilden, so dass der Innenkühlkörper 24 ohne Naht- und Fügestelle aus demselben Material einstückig durch den Gehäusewandabschnitt 22 gebildet ist.

Der Innenkühlkörper 24 weist vom Gehäusewandabschnitt 22 quer in den Innenraum 13 hineinragende Rippen 25 auf, die mit Abstand zueinander angeordnet sind. In den Zwischenräumen sind Kanäle 26 gebildet (Figur 6) und durch jeweils zwei benachbarte Rippen 25 begrenzt, die in Strömungsrichtung der Kühlungsströmung S verlaufen und beim Ausführungsbeispiel in etwa vertikal ausgerichtet sind. Die Kühlungsströmung S kann ausgehend von der Ausströmseite 20 des Ventilators durch die Kanäle 26 des Innenkühlkörpers 24 durchströmen und an der dem Ventilator 18 entgegengesetzten Seite des Innenkühlkörpers 24 wieder austreten. Durch diesen Innenkühlkörper 24 ist der durch Konvektionskühlung bewirkte Wärmeübergang von der im Innenraum 13 vorhandenen Luft über den Innenkühlkörper 24 auf den Gehäusewandabschnitt 22 verbessert.

Eine erfindungsgemäße Verbesserung des Wärmetransports vom Innenraum 13 zur Umgebung 12 wird dadurch erreicht, dass an der Außenseite des Gehäuses 10 ein Außenkühlkörper 30 vorhanden ist (Figuren 2 bis 7). Auch der Außenkühlkörper 30 kann mehrere mit Abstand zueinander angeordnete Rippen 31 aufweisen. Bei den Beispielen gemäß der Figuren 2 bis 5 deckt der Außenkühlkörper 30 die gesamte Außenseite der seitlichen Gehäusewand 11s ab, an der sich der angeströmte Gehäusewandabschnitt 22 befindet. Dadurch wird die zur Wärmeabgabe verfügbare Oberfläche deutlich vergrößert. Es ist in Abwandlung hierzu auch möglich, den Außenkühlkörper 30 kleiner auszuführen als die Außenfläche der seitlichen Gehäusewand 11s. Wie der Innenkühlkörper 24 kann der Außenkühlkörper 30 durch ein separates Bauteil und/oder durch die seitliche Gehäusewand 11s gebildet sein.

Sowohl der Innenkühlkörper 24, wie auch der Außenkühlkörper 30 sind als separate Bauelemente aus einem Material hergestellt, dessen Wärmeleitfähigkeit größer ist als die Wärmeleitfähigkeit der Gehäusewände 11.

Zwischen dem Gehäusewandabschnitt 22 und dem Innenkühlkörper 24 bzw. dem Außenkühlkörper 30 ist eine unmittelbare, flächige Verbindung hergestellt. Wie in Figur 6 gestrichelt dargestellt, kann optional eine Wärmeleitschicht 33 zwischen dem Gehäusewandabschnitt 22 und einem oder beiden Kühlkörpern 24, 30 angeordnet sein, die beispielsweise von einer Grafitfolie gebildet ist. Eine solche Wärmeleitschicht 33 kann die flächige Wärmeverteilung verbessern.

Bei den Beispielen gemäß der Figuren 4 und 5 ist die Luftleitanordnung 15 zwischen der Ausströmseite 20 des Ventilators 18 und dem Innenkühlkörper 24 angeordnet. Die Luftleitanordnung 15 dient hier dazu, das an der Ausströmseite 20 vom Ventilator 18 ausströmende Gas - beispielsweise Luft - zum Innenkühlkörper 24 und insbesondere 24 durch die dort vorhandenen Kanäle 26 zu lenken. Hierfür kann die Luftleitanordnung 15 wenigstens ein Leitblech aufweisen.

Bei den Beispielen nach Figuren 4, 5 und 9 umschließen die Leitbleche den Rand der Ausströmseite 20 des Ventilators 18 an mehreren Seiten und bilden beispielsweise gemeinsam mit der Gehäusewand 11, an der der Ventilator 18 angebracht ist, den Luftleitkanal 16.

Der Ventilator 18 kann im Prinzip an jeder beliebigen Stelle innerhalb eines Luftleitkanals 16 angeordnet sein. Wesentlich ist, dass ein Abschnitt des Luftleitkanals 16 entlang des Gehäusewandabschnitts 22 verläuft und die Ansaugöffnung 17a weiter oben angeordnet ist als die Ausströmöffnung 17b.

Um den Wärmeübergang zwischen dem Gehäusewandabschnitt 22 und zumindest einem der beiden Kühlkörper 24, 30 zu verbessern, ist bei einer erfindungsgemäßen Ausführung (Figur 6) wenigstens ein Wärmeleitelement 34 vorhanden sein, das in dem Gehäusewandabschnitt 22 fluiddicht bzw. in einer dem Explosionsschutz entsprechenden Weise angeordnet ist und den Innenkühlkörper 24 und den Außenkühlkörper 30 verbinden kann. Innen und außen sind in den Gehäusewandabschnitt 22 Sacklöcher eingebracht, die den Gehäusewandabschnitt 22 nicht vollständig durchsetzen, sondern lediglich Vertiefungen bilden, in denen die Wärmeleitelemente 34 angeordnet sind.

Die Form, die Kontur, die Anzahl und die Anordnung solcher Wärmeleitelemente 34 kann beliebig gewählt werden. Die Wärmeleitelemente 34 sind aus einem Material hergestellt, dessen Wärmeleitfähigkeit größer ist als die Wärmeleitfähigkeit des Materials der Gehäusewände 11. Die Wärmeleitelemente 34 sind beispielsgemäß massiv ohne Hohlräume ausgeführt und weisen kein Strömungsmedium auf. Bei der erfindungsgemäßen Ausführungsform nach Figur 6 sind außen und innen in der Gehäusewand 11 angeordneten Wärmeleitelemente 34 versetzt angeordnet. Alternativ könnten die außen und innen angeordneten Wärmeleitelemente 34 auch unmittelbar gegenüberliegend angeordnet sein.

Figur 7 zeigt schematisch ein nicht erfindungsgemäßes Beispiel zur Anordnung des Innenkühlkörpers 24 und des Außenkühlkörpers 30. Um die Wärmeleitung zwischen den beiden Kühlkörper 24, 30 zu verbessern, ist eine unmittelbare, flächige Verbindung zwischen dem Innenkühlkörper 24 und dem Außenkühlkörper 30 vorgesehen. Hierfür muss in dem abgeströmten Gehäusewandabschnitt 22 eine Wandaussparung 35 eingebracht sein. Wenigstens einer der beiden Kühlkörper 24, 30 durchgreift die Wandaussparung 35, so dass seine dem Innenraum 13 abgewandte Rückfläche 36 an der dem Gehäuse 10 bzw. dem Gehäusewandabschnitt 22 zugewandten Rückfläche 37 des Außenkühlkörpers 30 anliegen kann. Die beiden Rückflächen 36, 37 können wie in Figur 7 veranschaulicht unmittelbar aneinander anliegen oder über eine wärmeleitende Schicht, beispielsweise eine Grafitschicht flächig miteinander verbunden sein.

Zur Aufrechterhaltung des Explosionsschutzes wird die Wandaussparung 35 beim Beispiel fluiddicht verschlossen. Dies geschieht beispielsgemäß dadurch, dass die Rückfläche 37 des Außenkühlkörpers 30 ringsumlaufend mit einem Rand 38 über die Wandaussparung 35 hinausragt. Mithilfe des Randes 38 wird die Wandaussparung 35 verschlossen. Bei dem hier beschriebenen Beispiel ist zur Erreichung eines fluiddichten Abschlusses ein Dichtungselement 39 zwischen dem Rand 38 des Außenkühlkörpers 30 und der die Wandaussparung 35 aufweisenden Gehäusewand 11 angeordnet.

Allerdings würde bei der in Figur 7 dargestellten Verbindungsmöglichkeit zwischen dem Innenkühlkörper 24 und dem Außenkühlkörper 30 der Explosionsschutz des Gehäuses 10 beeinträchtigt oder es wäre zusätzlicher Aufwand erforderlich. Dies soll erfindungsgemäß gerade vermieden werden. Deswegen erfolgt die wärmeleitende Verbindung erfindungsgemäß unter Zwischenschaltung des Gehäusewandabschnitts 22.

### Bezugszeichenliste:

- 10: Gehäuse
- 11: Gehäusewand
- 11o: obere Gehäusewand
- 11s: seitliche Gehäusewand
- 11u: untere Gehäusewand
- 12: Umgebung
- 13: Innenraum
- 14: Komponente
- 15: Luftleitanordnung
- 16: Luftleitkanal
- 17: Ventilatoranordnung
- 17a: Ansaugöffnung
- 17b: Ausströmöffnung
- 18: Ventilator
- 19: Ansaugseite
- 20: Ausströmseite

- 22: Gehäusewandabschnitt
- 23: Strömungsraum
- 24: Innenkühlkörper
- 25: Rippe
- 26: Kanal

- 30: Außenkühlkörper
- 31: Rippe

- 33: Wärmeleitschicht
- 34: Wärmeleitelement
- 35: Wandaussparung
- 36: Rückfläche des Innenkühlkörpers
- 37: Rückfläche des Außenkühlkörpers
- 38: Rand
- 39: Dichtungselement

- S: Kühlungsströmung

## Patentansprüche

1. Anordnung aufweisend:
ein explosionsgeschütztes Gehäuse (10) mit einem relativ zur Umgebung (12) durch Gehäusewände (11) gekapselten, explosionsgeschützten Innenraum (13), in dem elektrische und/oder elektronische Komponenten (14) angeordnet sind,
eine im Innenraum (13) angeordnete Ventilatoranordnung (17) mit einem Ventilator (18), wobei die Ventilatoranordnung (17) eine Ansaugöffnung (17a) und eine unterhalb der Ansaugöffnung (17a) angeordnete Ausströmöffnung (17b) aufweist, und wobei die Ventilatoranordnung (17) im Innenraum (13) eine vertikal nach unten gerichtete Kühlungsströmung (S) entlang eines Gehäusewandabschnitts (22) einer seitlichen Gehäusewand (11) hervorruft, die frei ist von kühlungsmediumdurchströmten Öffnungen,
einen an der Außenseite des Gehäuses (10) vorhandenen Außenkühlkörper (30),
**dadurch gekennzeichnet,**
**dass** die Ventilatoranordnung (17) an einer seitlichen Gehäusewand (11) angeordnet ist,
**dass** die von der Kühlungsströmung angeströmte seitliche Gehäusewand (11) von einer Tür oder Klappe gebildet ist,
**dass** im Innenraum (13) in der Kühlungsströmung (S) ein Innenkühlkörper (24) vorhanden ist, wobei der Innenkühlkörper (24) und der Außenkühlkörper (30) an dem Gehäusewandabschnitt (22) der seitlichen Gehäusewand (11) angeordnet sind und durch die seitliche Gehäusewand (11) voneinander getrennt sind,
und **dass** innen und außen Sacklöcher in den Gehäusewandabschnitt (22) eingebracht sind, die den Gehäusewandabschnitt (22) nicht vollständig durchsetzen, sondern lediglich Vertiefungen bilden, in denen Wärmeleitelemente (34) angeordnet sind, um den Wärmeübergang zwischen dem Gehäusewandabschnitt (22) und dem Innenkühlkörper (24) und dem Außenkühlkörper (30) zu verbessern.

2. Anordnung nach Anspruch 1, **dadurch gekennzeichnet, dass** die Ansaugöffnung (17a) in dem oberen Drittel oder dem oberen Viertel des Innenraums (13) angeordnet ist.

3. Anordnung nach Anspruch 1 oder 2, **dadurch gekennzeichnet, dass** sich an den Ventilator (18) ein Strömungsraum (23) im Innenraum (13) des Gehäuses (10) entlang des Gehäusewandabschnitts (22) anschließt, der frei ist von zu kühlenden elektrischen und/oder elektronischen Komponenten (14).

4. Anordnung nach Anspruch 3, **dadurch gekennzeichnet, dass** der Innenkühlkörper (24) in dem sich an den Ventilator (18) anschließenden Strömungsraum (23) angeordnet ist.

5. Anordnung nach einem der vorhergehenden Ansprüche, **dadurch gekennzeichnet, dass** der Innenkühlkörper (24) in Strömungsrichtung der Kühlungsströmung (S) verlaufende, zumindest an drei Seiten begrenzte Kanäle (26) aufweist.

6. Anordnung nach einem der vorhergehenden Ansprüche, **dadurch gekennzeichnet, dass** zwischen dem Innenkühlkörper (24) und dem Ventilator (18) eine Leiteinrichtung (42) angeordnet ist.

7. Anordnung nach einem der vorhergehenden Ansprüche, **gekennzeichnet durch** eine Ausführung in der Zündschutzart "druckfeste Kapselung".

## Claims

1. Arrangement having:
an explosion-proof housing (10) with an explosion-proof interior (13) which is encapsulated by housing walls (11) relative to the environment (12) and in which electrical and/or electronic components (14) are arranged,
a ventilator arrangement (17) with a ventilator (18) provided in the interior (13), wherein the ventilator arrangement (17) has an intake opening (17a) and an outflow opening (17b) arranged below the intake opening (17a), and wherein in the interior (13) the ventilator arrangement (17) provokes a cooling stream (S) directed vertically downward along a housing wall portion (22) of a lateral housing wall (11) which is free from orifices through which cooling medium flows,
an external cooling body (30) provided on the outside of the housing (10),
**characterised in that**
the ventilator arrangement (17) is arranged on a lateral housing wall (11),
the lateral housing wall (11) onto which the cooling stream flows is formed by a door or hatch,
an inner cooling body (24) is present in the interior (13) in the cooling stream (S), wherein the inner cooling body (24) and the outer cooling body (30) are arranged on the housing wall portion (22) of the lateral housing wall (11) and are separated from each other by the lateral housing wall (11),
and inner and outer blind holes are made in the housing wall portion (22) which do not penetrate completely through the housing wall portion (22) but merely form recesses in which heat-conductive elements (34) are arranged in order to improve the heat transmission between the housing wall portion (22) and the inner cooling body (24) and the outer cooling body (30).

2. Arrangement according to claim 1, **characterised in that** the intake opening (17a) is arranged in the upper third or upper quarter of the interior (13).

3. Arrangement according to claim 1 or 2, **characterised in that** a flow chamber (23) adjoins the ventilator (18) in the interior (13) of the housing (10) along the housing wall portion (22) which is free from electrical and/or electronic components (14) to be cooled.

4. Arrangement according to claim 3, **characterised in that** the inner cooling body (24) is arranged in the flow chamber (23) adjoining the ventilator (18).

5. Arrangement according to any of the preceding claims, **characterised in that** the inner cooling body (24) has channels (26) delimited on at least three sides and running in the flow direction of the cooling stream (S).

6. Arrangement according to any of the preceding claims, **characterised in that** a guide device (42) is arranged between the inner cooling body (24) and the ventilator (18).

7. Arrangement according to any of the preceding claims, **characterised by** a design of the explosion-protection type "pressure-resistant encapsulation".

## Revendications

1. Dispositif comprenant :
un boîtier antidéflagrant (10), doté d'un espace intérieur (13) antidéflagrant qui est blindé vis-à-vis de l'environnement (12) par des parois de boîtier (11) et dans lequel sont installés des composants (14) électriques et/ou électroniques,
un agencement de ventilateur (17) disposé dans l'espace intérieur (13) et comportant un ventilateur (18), l'agencement de ventilateur (17) présentant une ouverture d'aspiration (17a) et une ouverture de sortie (17b) disposée en dessous de l'ouverture d'aspiration (17a), et l'agencement de ventilateur (17) générant dans l'espace intérieur (13) un courant de refroidissement (S) qui est dirigé verticalement vers le bas, le long d'une partie de paroi de boîtier (22) d'une paroi de boîtier latérale (11) qui est dépourvue d'orifices traversés par le fluide de refroidissement,
un corps de refroidissement extérieur (30) prévu sur la face externe du boîtier (10),
**caractérisé en ce que**
l'agencement de ventilateur (17) est disposé sur une paroi de boîtier latérale (11),
que la paroi de boîtier latérale (11) sur laquelle passe le courant de refroidissement est constituée d'une porte ou d'un clapet,
qu'un corps de refroidissement intérieur (24) est prévu dans l'espace intérieur (13), dans le courant de refroidissement (S), le corps de refroidissement intérieur (24) et le corps de refroidissement extérieur (30) étant disposés sur la partie de paroi de boîtier (22) de la paroi de boîtier latérale (11) et étant séparés l'un de l'autre par la paroi de boîtier latérale (11),
et **en ce que**, à l'intérieur et à l'extérieur, des trous borgnes sont ménagés dans la partie de paroi de boîtier (22), qui ne traversent pas complètement la partie de paroi de boîtier (22) mais forment seulement des parties en retrait dans lesquelles sont disposés des éléments thermoconducteurs (34) destinés à améliorer le transfert de chaleur entre la partie de paroi de boîtier (22) et le corps de refroidissement intérieur (24) et le corps de refroidissement extérieur (30).

2. Dispositif selon la revendication 1, **caractérisé en ce que** l'ouverture d'aspiration (17a) est disposée dans le tiers supérieur ou le quart supérieur de l'espace intérieur (13).

3. Dispositif selon la revendication 1 ou 2, **caractérisé en ce qu'**un espace d'écoulement (23) est situé à la suite du ventilateur (18), dans l'espace intérieur (13) du boîtier (10), le long de la partie de paroi de boîtier (22), lequel espace ne comporte pas de composants (14) électriques et/ou électroniques de refroidissement.

4. Dispositif selon la revendication 3, **caractérisé en ce que** le corps de refroidissement intérieur (24) est disposé dans l'espace d'écoulement (23) situé à la suite du ventilateur (18).

5. Dispositif selon l'une des revendications précédentes, **caractérisé en ce que** le corps de refroidissement intérieur (24) présente des canaux (26) qui s'étendent dans le sens d'écoulement du courant de refroidissement (S) et sont délimités sur au moins trois côtés.

6. Dispositif selon l'une des revendications précédentes, **caractérisé en ce qu'**un dispositif conducteur (42) est placé entre le corps de refroidissement intérieur (24) et le ventilateur (18)

7. Dispositif selon l'une des revendications précédentes, **caractérisé en ce qu'**il est réalisé avec la protection de type « enveloppe antidéflagrante ».
